# FASCICULE DE BREVET EUROPEEN

(11) **EP 1 614 330 B1**
(45) Date de publication et mention de la délivrance du brevet: **10.09.2008**
(21) Numéro de dépôt: 04727259.6
(22) Date de dépôt: 14.04.2004
(51) Int. Cl.: H05K 5/02

(54) **BOITIER COMPORTANT UN CONDUIT DE CIRCULATION D`AIR EMPECHANT TOUTE ACCUMULATION DE LIQUIDE**
GEHÄUSE MIT EINEM UMLUFTROHR ZUR VERHINDERUNG DER FLÜSSIGKEITSANSAMMLUNG
HOUSING COMPRISING AN AIR FLOW CONDUIT PREVENTING ALL LIQUID ACCUMULATION

(30) Priorité: 16.04.2003 FR 0304791
(43) Date de publication de la demande: 11.01.2006
(73) Titulaire: VALEO SYSTEMES D'ESSUYAGE, 78321 La Verrière (FR)
(72) Inventeur: LORIN, Hervé, F-86000 Poitiers (FR)
(86) Numéro de dépôt international: PCT/EP2004/003912
(87) Numéro de publication internationale: WO 2004/093509

(56) Documents cités:
- EP-A- 0 377 067
- WO-A-96/03629
- DE-A1- 3 716 912
- US-B1- 6 486 398

## Description

L'invention propose un boîtier pour un dispositif électronique et/ou électrique, comme par exemple le dispositif de commande d'un moteur électrique, qui est fermé de manière étanche aux liquides, et de manière perméable à l'air.

L'invention propose plus particulièrement un boîtier fermé de manière étanche dans le volume intérieur duquel est agencé un dispositif électrique ou électronique, du type qui comporte un canal d'axe principal globalement vertical qui traverse une paroi supérieure du boîtier pour relier le volume intérieur du boîtier à l'extérieur, et du type qui comporte des moyens d'obturation du canal de manière étanche aux liquides et de manière perméable aux gaz.

Les dispositifs électriques et/ou électroniques, comme par exemple le calculateur électronique d'un moteur à combustion interne, ou le dispositif de commande d'un moteur électrique d'entraînement d'un mécanisme d'essuyage, sont parfois agencés dans le compartiment moteur du véhicule automobile qu'ils équipent.

Ces dispositifs sont particulièrement sensibles aux projections de liquides, et aux poussières, c'est pourquoi ils sont généralement agencés dans un boîtier fermé de manière étanche.

Au cours de son utilisation, un dispositif électronique se réchauffe et réchauffe l'air présent à l'intérieur du boîtier, ce qui provoque une dilatation, et donc une augmentation de la pression de l'air. Bien que le boîtier soit fermé de manière étanche, une partie de l'air dilaté s'échappe vers l'extérieur du boîtier, notamment à cause de la différence de pression entre l'intérieur du boîtier et l'extérieur.

Lorsque le dispositif électronique est au repos, sa température, ainsi que celle de l'air présent à l'intérieur du boîtier, baisse, ce qui provoque une chute de pression à l'intérieur du boîtier d'habillage. De l'air extérieur pénètre alors l'intérieur du boîtier d'habillage.

L'air extérieur est généralement chargé d'humidité qui s'accumule et se condense à l'intérieur du boîtier au fur et à mesure de la répétition de ces phases d'utilisation et de repos du dispositif électronique. L'eau condensée ainsi accumulée est une source potentielle de courts-circuits et d'oxydation des composants du dispositif électronique, ce qui peut nuire fortement à son fonctionnement.

Afin d'empêcher cette accumulation d'humidité à l'intérieur du boîtier, il a été proposé des boîtiers comportant un système appelé "respirateur", permettant une circulation d'air entre l'intérieur du boîtier et l'extérieur, et donc un équilibrage des pressions, tout en évitant l'accumulation d'humidité à l'intérieur du boîtier.

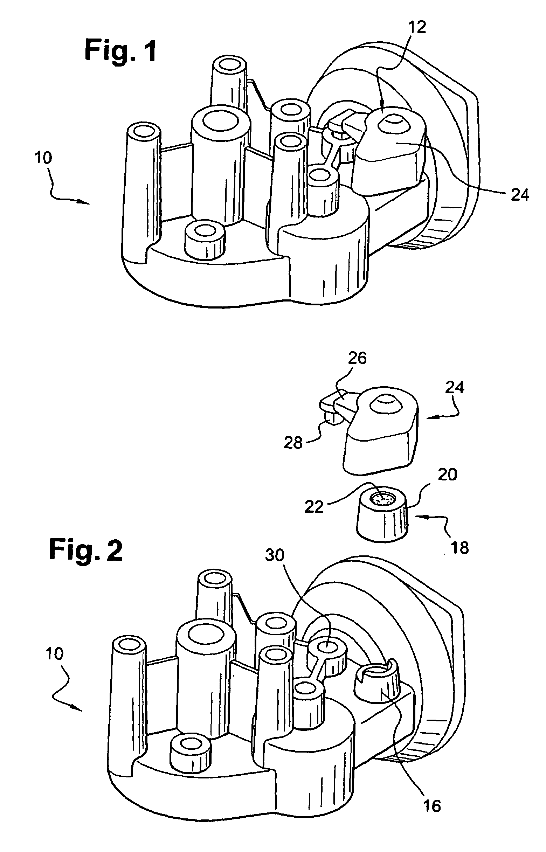

On a représenté aux figures 1 et 2 un élément ou corps10 du boîtier d'habillage d'un dispositif d'entraînement de mécanisme d'essuyage, qui comporte un respirateur 12 selon un mode de réalisation connu.

Le respirateur 12 comporte un canal 14 qui traverse le corps 10 pour relier le volume intérieur du boîtier avec l'extérieur, et qui est prolongé vers l'extérieur par un conduit 16 conique.

Le respirateur 12 comporte aussi un embout 18 d'obturation du canal 14 de manière étanche aux liquides et de manière perméable à l'air.

L'embout 18 comporte un manchon 20 qui recouvre le conduit conique 16 et qui est fixé à ce dernier par tous moyens conventionnels, comme par exemple par emboîtement conique ou par collage, de manière que la liaison entre le manchon 20 et le conduit conique 16 soit étanche. Le manchon 20 porte, au niveau de son extrémité supérieure, une membrane 22 qui s'étend au travers du canal 14. La membrane 22 est réalisée en un matériau perméable à l'air et étanche à l'eau, comme par exemple en tissu connue sous la marque "GORE-TEX^{®}".

Le mécanisme d'essuyage associée au pare-brise avant d'un véhicule automobile est généralement agencé sous le capot du véhicule, dans un compartiment appelé "boite à eau".

D'une manière générale, ce compartiment est ouvert et communique avec l'extérieur par l'intermédiaire de grilles de protection réalisée dans le capot du véhicule, et qui empêchent que des objets volumineux, notamment des feuilles ou des graviers, ne pénètrent dans le compartiment. Cependant, ces grilles de protection n'empêchent pas les liquides de pénétrer dans le compartiment.

Ainsi, selon la disposition du mécanisme d'essuyage dans le compartiment, le respirateur peut être exposé aux projections de liquides. Lorsque ces liquides arrivent sur le respirateur 12 avec une vitesse élevée, comme c'est le cas par exemple lorsque l'utilisateur nettoie son véhicule à l'aide d'un nettoyeur haute pression, il risque d'endommager fortement la membrane 22.

C'est pourquoi le respirateur 12 est associée à un capuchon 24 qui recouvre l'embout 18 de manière à empêcher toute projection d'éléments directement sur la membrane 22.

Le capuchon 24 est fixé au corps 10 par intermédiaire d'une patte de fixation 26 comportant un doigt 28 apte à être reçu dans un logement complémentaire 30 du corps 10.

Bien que ce respirateur 12 permette d'assurer une parfaite isolation du volume intérieur du boîtier, il comporte un nombre de pièces important, et l'assemblage de ces pièces est relativement complexe car il nécessite le positionnement précis des pièces par rapport au corps 10.

Les documents FR-A-2.758.873 et US-A-5.894.180 décrivent d'autres modes de réalisation de respirateurs selon lesquels la membrane est fixée au corps, en travers du canal reliant l'intérieur du boîtier avec l'extérieur, et elle est protégée d'éventuelles projections par un couvercle de protection.

Selon ces modes de réalisation, le respirateur est de conception relativement simple. Cependant, de l'eau peut s'accumuler dans le canal et recouvrir en totalité la face externe de la membrane, empêchant ainsi la circulation d'air entre l'intérieur du boîtier et l'extérieur.

L'invention a pour but de proposer un boîtier qui comporte un respirateur de conception relativement simple, et qui permettent d'éviter toute accumulation de liquide sur la face externe de la membrane.

Dans ce but, l'invention propose un boîtier du type décrit précédemment, caractérisé en ce que les moyens d'obturation sont agencés au moins en partie sur la paroi supérieure du boîtier et au niveau de l'extrémité supérieure du canal, de manière à empêcher toute accumulation de liquide dans le canal.

Selon d'autres caractéristiques de l'invention :
- les moyens d'obturation comportent une membrane étanche aux liquides et perméable aux gaz qui s'étend globalement horizontalement de manière à obturer le canal ;
- la membrane est fixée sur la face externe de la paroi supérieure, en faisant saillie vers le haut par rapport à la paroi supérieure ;
- les moyens d'obturation comportent un couvercle qui est fixé à la face externe de la paroi supérieure de manière à s'étendre au-dessus de l'extrémité supérieure du canal ;
- le couvercle s'étend à distance de l'extrémité supérieure du canal ;
- le couvercle comporte une plaque qui s'étend horizontalement globalement parallèlement à la paroi supérieure, et dont la face inférieure, en vis-à-vis de l'extrémité supérieure du canal porte un doigt vertical qui est reçu en partie dans le canal ;
- la paroi supérieure comporte une nervure annulaire qui s'étend verticalement vers le haut de manière à prolonger le canal, et le couvercle comporte une bague annulaire coaxiale à la nervure dont le diamètre interne est supérieur au diamètre externe de la nervure, qui s'étend verticalement vers le bas depuis la face inférieure de la plaque ;
- la bague comporte au moins une fente qui s'étend verticalement vers le haut depuis le bord inférieur d'extrémité libre de la bague jusqu'à la face inférieure de la plaque ;
- la membrane est fixée sur la face interne de la paroi supérieure ;
- la paroi supérieure comporte un orifice qui est traversé par des moyens de raccordement électrique du dispositif électronique, à un connecteur externe d'alimentation qui est fixé à la paroi supérieure du boîtier ;
- le couvercle est porté par le connecteur.

D'autres caractéristiques et avantages de l'invention apparaîtront à la lecture de la description détaillée qui suit pour la compréhension de laquelle on se reportera aux figures annexées parmi lesquelles :
- la figure 1 est une représentation schématique en perspective d'un boîtier comportant un respirateur conforme à un mode de réalisation antérieur ;
- la figure 2 est une vue similaire à celle de la figure 1, dans laquelle le respirateur est représenté en éclaté ;
- la figure 3 est une représentation schématique en perspective d'un dispositif d'entraînement comportant un respirateur conforme à l'invention ;
- la figure 4 est une représentation schématique en éclaté du mécanisme d'entraînement représenté à la figure 3 ;
- la figure 5 est un éclaté à plus grande échelle du respirateur représenté à la figure 3 ;
- la figure 6 est une section transversale du respirateur représenté à la figure 3 ;
- la figure 7 est un détail en vue de dessous du connecteur selon le mode de réalisation représentée à la figure 5 ;
- la figure 8 est une vue similaire à celle de la figure 5, représentant une variante de réalisation de l'invention ;
- la figure 9 est un détail en vue de dessous du connecteur selon la variante de réalisation représentée à la figure 8 ;
- la figure 10 est une vue similaire à celle de la figure 3, représentant un autre mode de réalisation du respirateur conforme à l'invention ;
- la figure 11 est une vue similaire à celle de la figure 9, du connecteur conforme au mode de réalisation de la figure 10 ;
- la figure 12 est une vue similaire à celle de la figure 3, représentant un autre mode de réalisation du respirateur conforme à l'invention ;

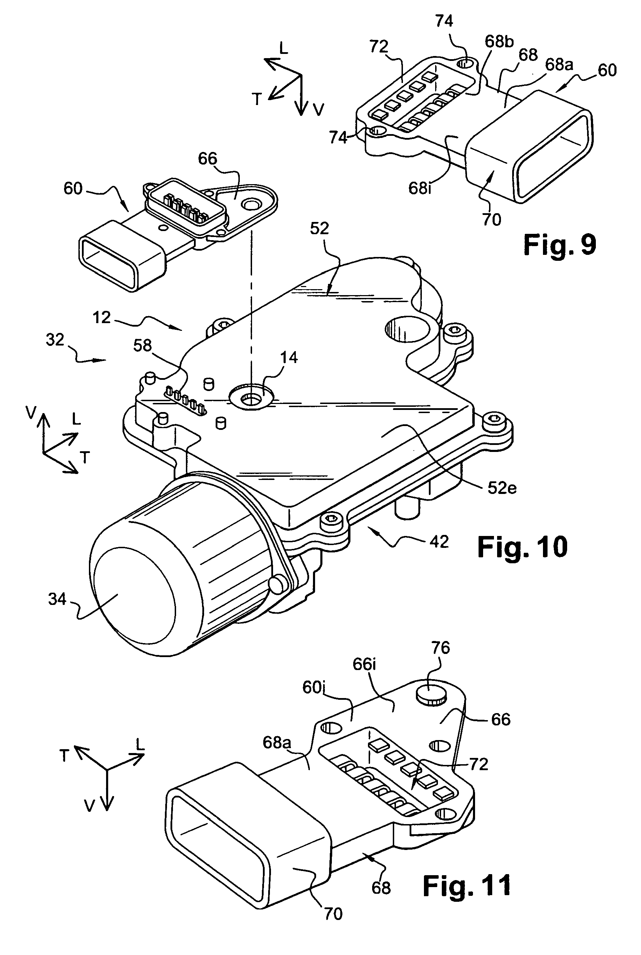

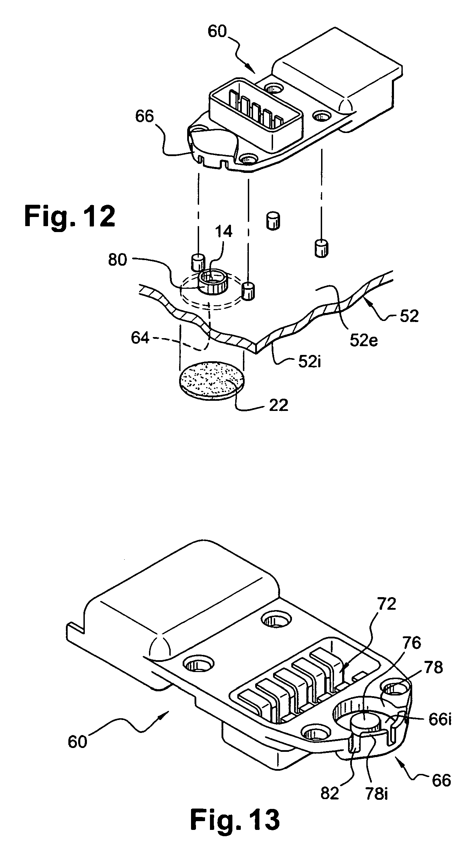

- la figure 11 est une vue similaire à celle de la figure 9, du connecteur conforme au mode de réalisation de la figure 12.

Pour la description de l'invention, on adoptera à titre non limitatif les orientations verticale, longitudinale et transversale selon le repère V, L, T indiqué aux figures.

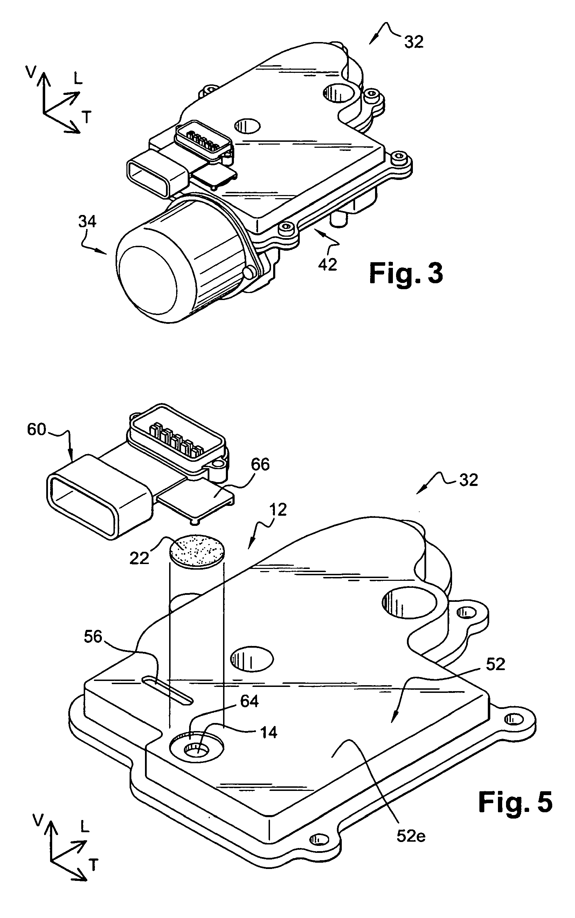

On adoptera aussi l'orientation d'arrière en avant comme étant la direction longitudinale et de droite à gauche en se reportant à la figure 3.

Dans la description qui va suivre, des éléments identiques, similaires ou analogues seront désignés par les mêmes chiffres de référence.

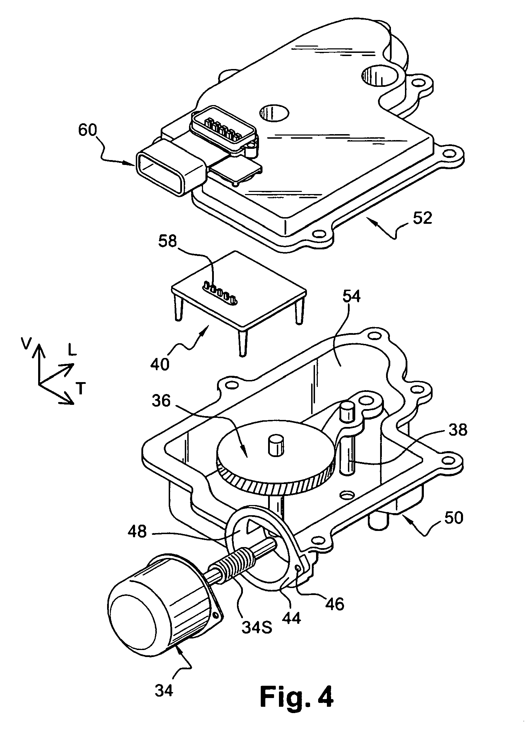

On a représenté aux figures 3 et 4 un dispositif d'entraînement 32 d'un mécanisme d'essuie-glace (non représenté) qui comporte un moteur électrique 34, un mécanisme 36 de transformation du mouvement de rotation continue de l'arbre de sortie 34s du moteur 34 en un mouvement de rotation alternée d'un arbre d'entraînement 38, que l'on appellera par la suite réducteur, et un dispositif électronique 40 de commande du moteur 34.

Le dispositif d'entraînement 32 comporte aussi un boîtier 42 à l'intérieur duquel sont agencés le dispositif électronique 40 et le réducteur 36. Le boîtier 42 comporte des moyens de fixation du moteur 34, qui consistent ici en une collerette annulaire 44, et des trous taraudés 46 agencés autour d'un orifice 48 de passage de l'arbre de sortie 34s du moteur 34, et des moyens de fixation du dispositif d'entraînement 32 a un élément de structure de caisse du véhicule.

Le boîtier 42 comporte une coquille inférieure 50 qui porte des moyens (non représentés) de support du réducteur 36 et du dispositif électronique 40, elle comporte un orifice (non représenté) de passage de l'arbre d'entraînement 38, et les moyens de fixation du moteur d'entraînement 34 au boîtier 42.

Le boîtier 42 comporte aussi une plaque de fermeture 52 qui délimite, en association avec la coquille inférieure 50 le volume intérieur 54 du boîtier 42.

La plaque de fermeture 52 comporte un orifice 56 de passage de pattes de raccordement électrique 58 du dispositif électronique 40 à un connecteur externe d'alimentation 60 qui est lui-même fixé à la plaque de fermeture 52.

Le boîtier 42 est fermé de manière étanche aux liquides et de manière perméable à l'air. Pour cela, la coquille inférieure 50 est fixée au moteur d'entraînement 34 et à la plaque de fermeture 52 de manière étanche, et les orifices de passage de l'arbre d'entraînement 38 et des pattes de connexion 58 sont obturées par des moyens d'étanchéité du type connu, notamment en caoutchouc.

Enfin, le boîtier 42 comporte des moyens 12 formant "respirateur" qui permettent la circulation d'air entre le volume intérieur 54 du boîtier 42 et l'extérieur, qui sont agencés sur la plaque de fermeture 52.

Comme on peut le voir plus en détail à la figure 5, le respirateur 12 comporte un canal 14 d'axe principal vertical qui traverse la plaque de fermeture 52 en reliant le volume intérieur 54 du boîtier 42 avec l'extérieur, et une membrane 22 qui obture le canal 14 de manière perméable aux gaz, et de manière étanche au liquides. La membrane 22 est par exemple réalisée en matériau connu sous la marque GORE-TEX^{®}.

La membrane 22 obture le canal 14, c'est-à-dire qu'elle s'étend globalement horizontalement, et elle est fixée à la plaque de fermeture 52 par tous moyens connus, notamment par collage.

Il est connu d'agencer la membrane 22 sur la face interne de la plaque de fermeture 52, ou bien dans le canal 14 à une cote verticale intermédiaire. Ainsi, de l'eau peut s'accumuler dans le canal 14, et recouvrir totalement la membrane 22. Il en résulte alors une obturation complète du canal 14.

C'est pourquoi, et conformément à l'invention, la membrane 22 est agencée sur la plaque de fermeture 52 de manière à empêcher toute accumulation d'eau dans le canal 14.

À cet effet, la membrane 22 est agencée de manière à faire saillie vers le haut par rapport à la face externe 52e de la plaque de fermeture 52.

Selon un premier mode de réalisation, la membrane 22 est fixée directement sur la face externe 52e de la plaque de fermeture 52. Cependant, l'état de surface de la face externe 52e de la plaque de fermeture 52 est parfois de mauvaise qualité, du fait du procédé de réalisation de la plaque de fermeture 52.

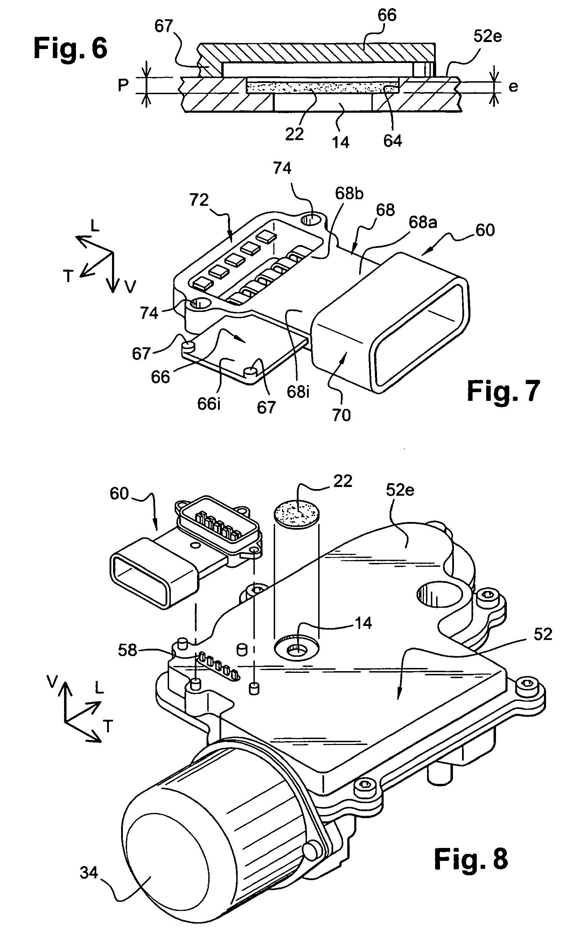

C'est pourquoi, selon un mode de réalisation préféré de l'invention, et comme on l'a représenté aux figures 5 et 6, la plaque de fermeture 52 comporte un lamage 64 coaxial au canal 14, qui s'étend verticalement vers le bas depuis la face externe 52e de la plaque de fermeture 52, et dont la profondeur "p" est inférieure à l'épaisseur "e" de la membrane 22.

Selon un autre mode de réalisation (non représenté), la plaque de fermeture 52 comporte un bossage coaxial au canal 14, qui s'étend verticalement vers le haut depuis la face externe 52e de la plaque de fermeture 52, et dont la face supérieure a été conformée, par exemple usinée, de manière à recevoir la membrane 22.

Selon la disposition du mécanisme d'entraînement 32 par rapport au véhicule, il se peut que la membrane 22 soit agencée à proximité d'une ouverture réalisée dans le capot du véhicule. La membrane 22 est alors exposée aux projections d'eau qui peuvent l'endommager.

Pour protéger la membrane 22 des projections d'eau, et conformément à un autre aspect de l'invention, les moyens formant le respirateur 12 comportent un couvercle 66 qui s'étend horizontalement au dessus de la membrane 22.

Le couvercle 66 s'étend à distance de la membrane 22 de manière à permettre la circulation d'air au travers de la membrane 22. Pour cela, le couvercle 66 comporte des pieds d'appui 67 contre la face externe 52e de la plaque de fermeture 52.

Selon un mode de réalisation préféré de l'invention, et comme on peut le voir aux figures 4 à 6, le couvercle 66 est réalisé venu de matière avec le connecteur 60.

Ainsi, il n'est pas nécessaire de prévoir de moyens de fixation du couvercle 66 à la plaque de fermeture 52, puisque ceux-ci sont déjà réalisés par les moyens de fixation du connecteur 60 à la plaque de fermeture 52.

De plus, cela permet d'associer un même mécanisme d'entraînement 32 à deux types de connecteur 60, comportant ou non un couvercle 66, sans qu'aucune modification des moyens de fixation du connecteur 60 à la plaque de fermeture 52 ne soit nécessaire.

Un connecteur 60 comportant un couvercle 66 conforme à l'invention est représenté à la figure 7, et il comporte, un corps central 68 de structure conventionnelle, qui s'étend globalement horizontalement, dont une extrémité longitudinale arrière 68a porte des moyens 70 de fixation d'un câble d'alimentation en énergie électrique (non représenté), et dont l'extrémité longitudinale avant 68b porte des moyens 72 de connexion électrique du câble d'alimentation aux pattes de connexion 58.

Lorsque le connecteur 60 est fixé au boîtier 42, la face inférieure 68i du corps 68 est en appui contre la face supérieure 52e de la plaque de fermeture 52. De plus, le connecteur comporte des orifices verticaux 74 qui sont aptes à recevoir des doigts de fixation représenté notamment à la figure 8 du connecteur 60 à la plaque de fermeture 52.

Le couvercle 66 est réalisé venu de matière avec le corps 68 du connecteur 60, et il s'étend transversalement depuis le bord latéral du corps 68.

Comme on l'a dit plus haut, le couvercle 66 s'étend au-dessus de la membrane 22, et la membrane 22 fait saillie vers le haut par rapport à la face supérieure 52e de la plaque de fermeture 52. Ainsi, la face inférieure 66i du couvercle 66 est décalée verticalement vers le haut par rapport à la face inférieure 68i du corps 68.

Enfin, pour empêcher que l'extrémité libre en porte-à-faux du couvercle 66 ne vienne en contact contre la membrane 22, ou la face supérieure 52e de la plaque de fermeture 52, le couvercle 66 comporte des pieds d'appui 67 qui s'étendent verticalement vers le bas depuis la face inférieure 66i du couvercle 66.

Le canal 14 est positionné sur la plaque de fermeture 52 de manière à s'étendre au dessous du couvercle 66 lorsque le connecteur 60 est en position montée sur la plaque de fermeture 52. Ici, le canal 14 est décalé transversalement par rapport au connecteur 60.

On a représenté à la figure 8 un autre mode de réalisation de l'invention selon lequel il n'existe aucun moyen de protection de la membrane 22 contre les projections de liquide.

Ce mode de réalisation est préférentiellement utilisé lorsque le mécanisme d'entraînement 32 est agencé dans un compartiment suffisamment fermé pour empêcher les projections d'eau n'atteignent la membrane 22.

Comme représenté à la figure 9, le connecteur 60 est alors un connecteur conventionnel qui ne comporte aucun aménagement particulier et qui ne comporte aucun élément du respirateur 12.

Le canal 14 est ici décalé longitudinalement vers l'avant par rapport au connecteur 60, cependant, il peut être positionné à un quelconque endroit de la plaque de fermeture 52 sans sortir du domaine de l'invention.

Le canal 14 est ici obturé par une membrane 22 qui est fixée à la plaque de fermeture 52 de manière à faire saillie vers le haut par rapport à la face externe 52e de la plaque de fermeture 52, comme cela a été décrit précédemment.

On a représenté à la figure 10 un boîtier de fermeture 42 dont la plaque de fermeture 52 est identique à celle du mode de réalisation représenté à la figure 8, c'est-à-dire que le canal 14 est décalé longitudinalement vers l'avant par rapport au connecteur 60 lorsque ce dernier est en position montée. Cependant, selon ce mode de réalisation, le canal 14 est obturé uniquement par un couvercle 66.

Comme on peut le voir plus en détail à la figure 11, le couvercle 66 s'étend longitudinalement vers l'avant depuis l'extrémité longitudinale avant 68a du corps 68, de manière que sa face inférieure 66i affleure avec la face inférieure 60i du connecteur 60, pour venir en contact avec la face externe 52e de la plaque de fermeture 52.

Le couvercle 66 comporte aussi un doigt vertical 76 qui s'étend verticalement vers le bas depuis la face inférieure 66i du couvercle 66, coaxialement au canal 14.

Lorsque le connecteur 60 est en position montée sur la plaque de fermeture 52, le doigt vertical 76 s'étend à l'intérieur du canal 14, et son diamètre externe est légèrement inférieur au diamètre interne du canal 14, de manière à empêcher que des éléments externes ne pénètrent dans le volume intérieur 54 du boîtier 42.

Le respirateur 12 ainsi décrit permet une circulation d'air entre le volume interne 54 du boîtier 42 et l'extérieur, cependant, ils ne permettent pas d'obturer le canal 14 de manière étanche aux liquides.

Ainsi, une même structure de la plaque de fermeture 52 peut être utilisée en association avec un respirateur 12 conforme à la quelconque des modes de réalisation décrits précédemment, c'est-à-dire qui comporte une membrane 22 et un couvercle 66, comme représenté à la figure 5, en utilisant seulement la membrane 22, comme représenté à la figure 8, ou bien en utilisant seulement un couvercle 66, comme représenté à la figure 10.

Le choix du respirateur 12, est effectué en considération de contraintes techniques dues à l'agencement du mécanisme d'entraînement 32 par rapport à l'élément de structure de caisse véhicule, ou bien en fonction de contraintes économiques du fait du coût élevé d'une membrane 22.

On a représenté aux figures 12 et 13 un autre mode de réalisation de l'invention selon lequel le canal 14 est obturé par une membrane 22 qui est fixée sur la paroi interne 52i de la plaque de fermeture 52.

Pour empêcher que de l'eau ne s'accumule dans le canal 14, la plaque de fermeture 52 comporte une nervure annulaire 78 qui s'étend verticalement vers le haut en prolongeant le canal 14. Ainsi, l'eau qui s'est accumulée sur la face externe 52e de la plaque de fermeture 52 ne peut pénétrer dans le canal 14 par ruissellement.

Pour empêcher que de l'eau ne pénètre dans le canal 14 par projection, la nervure 78 est recouverte par un couvercle 66, et, selon un mode de réalisation préféré, le couvercle 66 est porté par le connecteur 60.

Comme on peut le voir plus en détail à la figure 13, le couvercle 66 porte un doigt vertical 76 qui s'étend verticalement vers le bas depuis la face inférieure 66i du couvercle 66, de manière à être reçu dans le canal 14 lorsque le couvercle 66 est en position montée sur la plaque de fermeture 52.

Le couvercle 66 comporte aussi une bague annulaire 80 coaxiale à la nervure 78 et dont le diamètre interne est supérieur au diamètre externe de la nervure 78, de manière que lorsque le couvercle 66 est en position montée sur la plaque de fermeture 52, la bague 80 recouvre la nervure 78.

L'ensemble formé par la nervure 78, le doigt vertical 76 et la bague 80 forme un passage complexe à la manière d'une "chicane", qui empêche à tous éléments polluants solides ou liquides de pénétrer dans le canal 14.

Le mécanisme d'entraînement 32 à été décrit comme étant positionné de manière que la plaque de fermeture 52 délimite la paroi supérieure du boîtier 42, c'est-à-dire de manière qu'elle s'étende au-dessus de la coquille inférieure 50. Cette disposition est généralement utilisée lorsque l'arbre d'entraînement 38 est relié à plusieurs balais d'essuyage, par l'intermédiaire d'une tringlerie non représentée.

Cependant, il se peut que l'arbre d'entraînement 38 soit directement relié à un balai d'essuyage. Pour cela, il est nécessaire d'agencer le mécanisme d'entraînement 32 de manière que la plaque de fermeture 52 s'étende au-dessous de la coquille inférieure 50, c'est-à-dire que l'arbre d'entraînement 32 s'étende verticalement vers le haut.

Le canal 14 est alors orienté vers le bas, la nervure 78 et la face inférieure 66i du couvercle 66 délimitent alors une cuvette dans laquelle de l'eau peut s'accumuler, et donc obturer totalement le canal 14.

Pour éviter que de l'eau ne s'accumule dans cette cuvette, la nervure 78 comporte plusieurs rainures 82 qui s'étendent verticalement depuis le bord inférieur libre 78i de la nervure jusqu'à la face inférieure 66i du couvercle.

Ainsi, lorsque le mécanisme d'entraînement 32 est orienté de manière que l'arbre d'entraînement 38 s'étende vers le haut, l'eau qui aurait pu s'accumuler dans la cuvette s'écoule au travers des rainures 82.

Le couvercle 66 a été décrit comme étant un élément réalisé venu de matière avec le connecteur 60. Cependant, il sera compris que l'invention n'est pas limitée à ce mode de réalisation, et que le couvercle 66 peut être un élément indépendant du connecteur 60 qui est fixé à la plaque de fermeture 52, sans sortir du domaine technique de l'invention.

Il sera aussi compris que des inversions mécaniques simples peuvent constituer des variantes de réalisation de l'invention. Par exemple, le respirateur peut être agencé sur la coquille inférieure 50.

Cependant, la plaque de fermeture 52 consiste en un élément globalement plan, il est donc plus aisé de réaliser le canal 14 et le cas échéant le lamage 64 sur la plaque de fermeture que sur la coquille inférieure.

## Revendications

1. Boîtier (42) fermé de manière étanche dans le volume intérieur (54) duquel est agencé un dispositif électrique ou électronique (40),
qui comporte un canal (14) d'axe principal globalement vertical qui traverse une paroi supérieure (52) du boîtier (42) pour relier le volume intérieur (54) du boîtier (42) à l'extérieur, et
qui comporte des moyens d'obturation (22, 66) du canal (14) de manière étanche aux liquides et de manière perméable aux gaz,
les moyens d'obturation (22, 66) étant agencés au moins en partie sur la paroi supérieure (52) du boîtier (42) et au niveau de l'extrémité supérieure du canal (14), de manière à empêcher toute accumulation de liquide dans le canal (14)
**caractérisé en ce que** les moyens obturation (22, 66) comportent un couvercle (66) qui est fixé à la face externe (52e) de la paroi supérieure (52) de manière à s'étendre au-dessus de l'extrémité supérieure du canal (14), le couvercle (66) étant porté par un connecteur (60).

2. Boîtier (42) selon la revendication précédente, **caractérisé en ce que** les moyens d'obturation (22, 66) comportent une membrane (22) étanche aux liquides et perméable aux gaz qui s'étend globalement horizontalement de manière à obturer le canal (14).

3. Boîtier (42) selon la revendication précédente, **caractérisé en ce que** la membrane (22) est fixée sur la face externe (52e) de la paroi supérieure (52), en faisant saillie vers le haut par rapport à la paroi supérieure (52).

4. Boîtier (42) selon la revendication précédente, **caractérisé en ce que** le couvercle (66) s'étend à distance de l'extrémité supérieure du canal (14).

5. Boîtier (42) selon la revendication précédente, **caractérisé en ce que** le couvercle (66) comporte une plaque qui s'étend horizontalement globalement parallèlement à la paroi supérieure (52), et dont la face inférieure (66i), en vis-à-vis de l'extrémité supérieure du canal (14) porte un doigt (76) vertical qui est reçu en partie dans le canal (14).

6. Boîtier (42) selon la revendication précédente, **caractérisé en ce que** la paroi supérieure (52) comporte une nervure annulaire (78) qui s'étend verticalement vers le haut de manière à prolonger le canal (14), et **en ce que** le couvercle (66) comporte une bague annulaire (80) coaxiale à la nervure (78) dont le diamètre interne est supérieur au diamètre externe de la nervure (78), qui s'étend verticalement vers le bas depuis la face inférieure (66i) de la plaque.

7. Boîtier (42) selon la revendication précédente, **caractérisé en ce que** la bague (80) comporte au moins une rainure (82) qui s'étend verticalement vers le haut depuis le bord inférieur (80i) d'extrémité libre de la bague (80) jusqu'à la face inférieure (66i) de la plaque.

8. Boîtier (42) selon l'une des revendications 6 à 7, **caractérisé en ce que** la membrane (22) est fixée sur la face interne (52i) de la paroi supérieure (52).

9. Boîtier (42) selon l'une quelconque des revendications précédentes, **caractérisé en ce que** la paroi supérieur (52) comporte un orifice (56) qui est traversé par des moyens (58) de raccordement électrique du dispositif électronique (40), à un connecteur externe (60) d'alimentation qui est fixé à la paroi supérieure (52) du boîtier (42).

## Claims

1. A sealed box (42) in the internal volume (54) of which is arranged an electric or electronic device (40),
which includes a channel (14) having a substantially vertical major axis which goes through an upper wall (52) of the box (42) to connect the internal volume (54) of the box (42) with the outside, and
which includes closing means (22, 66) for the channel (14), so that it is liquid proof and gas permeable,
the closing means (22, 66) being arranged at least partially on the upper wall (52) of the box (42) and at the upper end of the channel (14), so as to prevent any accumulation of liquid in the channel (14),
**characterised in that** the closing means (22, 66) include a lid (66) which is fixed to the external face (52e) of the upper wall (52) so as to extend above the upper end of the channel (14), with the lid (66) being supported by a connector (60).

2. A box (42) according to the preceding claim, **characterised in that** the closing means (22, 66) include a liquid proof and gas permeable membrane (22) which extends substantially horizontally in order to close the channel (14).

3. A box (42) according to the preceding claim, **characterised in that** the membrane (22) is fixed on the external face (52e) of the upper wall (52), while protruding upwards with respect to the upper wall (52).

4. A box (42) according to the preceding claim, **characterised in that** the lid (66) extends away from the upper end of the channel (14).

5. A box (42) according to the preceding claim, **characterised in that** the lid (66) includes a plate which extends substantially horizontally, parallel to the upper wall (52), and the lower face of which (66i) opposite the upper end of the channel (14), supports a vertical finger (76) which is partially received in the channel (14).

6. A box (42) according to the preceding claim, **characterised in that** the upper wall (52) includes an annular rib (78) which extends vertically upwards so as to extend the channel (14), and **in that** the lid (66) includes an annular ring (80) coaxial with the rib (78), the inner diameter of which is greater than the outer diameter of the rib (78), which extends vertically downwards from the lower face (66i) of the plate.

7. A box (42) according to the preceding claim, **characterised in that** the ring (80) includes at least one groove (82) which extends vertically upwards from the lower edge (80i) of the free end of the ring (80) up to the lower face (66i) of the plate.

8. A box (42) according one of claims 6 to 7, **characterised in that** the membrane (22) is fixed on the internal face (52i) of the upper wall (52).

9. A box (42) according to any one of the preceding claims, **characterised in that** the upper wall (52) includes an orifice (56) which is gone through by electric connection means (58) for the electronic device (40), to an external supplying connector (60) which is fixed to the upper wall (52) of the box (42).

## Patentansprüche

1. Dicht verschlossenes Gehäuse (42), in dessen Innenraum (54) eine elektrische oder elektronische Vorrichtung (40) gestaltet ist,
die einen Kanal (14) mit insgesamt vertikaler Hauptachse umfaßt, der eine obere Wand (52) des Gehäuses (42) durchquert, um den Innenraum (54) des Gehäuses (42) mit außen zu verbinden, und
die Mittel für den Verschluß (22, 66) des Kanals (14) dicht gegen Flüssigkeiten und gasdurchlässig umfaßt,
wobei die Verschlußmittel (22, 66) zumindest teilweise auf der oberen Wand (52) des Gehäuses (42) und am oberen Ende des Kanals (14) so gestaltet sind, daß jegliche Ansammlung von Flüssigkeit im Kanal (14) verhindert wird,
**dadurch gekennzeichnet, daß** die Verschlußmittel (22, 66) einen Deckel (66) umfassen, der an der Außenseite (52e) der oberen Wand (52) so befestigt ist, daß er sich über dem oberen Ende des Kanals (14) erstreckt, wobei der Deckel (66) von einem Steckverbinder (60) getragen wird.

2. Gehäuse (42) nach dem vorstehenden Anspruch, **dadurch gekennzeichnet, daß** die Verschlußmittel (22, 66) eine gegen Flüssigkeiten dichte und gasdurchlässige Membran (22) umfaßt, die sich insgesamt horizontal so erstreckt, daß der Kanal (14) verschlossen wird.

3. Gehäuse (42) nach dem vorstehenden Anspruch, **dadurch gekennzeichnet, daß** die Membran (22) auf der Außenseite (52e) der oberen Wand (52) befestigt ist und dabei im Verhältnis zur oberen Wand (52) einen Vorsprung nach oben bildet.

4. Gehäuse (42) nach dem vorstehenden Anspruch, **dadurch gekennzeichnet, daß** sich der Deckel (66) im Abstand vom oberen Ende des Kanals (14) erstreckt.

5. Gehäuse (42) nach dem vorstehenden Anspruch, **dadurch gekennzeichnet, daß** der Deckel (66) eine Platte umfaßt, die sich horizontal insgesamt parallel zur oberen Wand (52) erstreckt, und deren Unterseite (66i) gegenüber dem oberen Ende des Kanals (14) einen vertikalen Zapfen (76) trägt, der teilweise im Kanal (14) aufgenommen wird.

6. Gehäuse (42) nach dem vorstehenden Anspruch, **dadurch gekennzeichnet, daß** die obere Wand (52) eine ringförmige Rippe (78) umfaßt, die sich vertikal nach oben erstreckt und dabei den Kanal (14) verlängert, und daß der Deckel (66) eine ringförmige Buchse (80) koaxial zur Rippe (78) umfaßt, deren Innendurchmesser größer als der Außendurchmesser der Rippe (78) ist, die sich ab der Unterseite (66i) der Platte vertikal nach unten erstreckt.

7. Gehäuse (42) nach dem vorstehenden Anspruch, **dadurch gekennzeichnet, daß** die Buchse (80) mindestens eine Rille (82) umfaßt, die sich ab der Unterkante (80i) des freien Endes der Buchse (80) bis zur Unterseite (66i) der Platte vertikal nach unten erstreckt.

8. Gehäuse (42) nach einem beliebigen der vorstehenden Ansprüche 6 bis 7, **dadurch gekennzeichnet, daß** die Membran (22) auf der Innenseite (52i) der oberen Wand (52) befestigt ist.

9. Gehäuse (42) nach einem beliebigen der vorstehenden Ansprüche, **dadurch gekennzeichnet, daß** die obere Wand (52) eine Öffnung (56) umfaßt, die von Mitteln (58) für den elektrischen Anschluß der elektronischen Vorrichtung (40) an einen äußeren Versorgungssteckverbinder (60) durchquert wird, der auf der Oberseite (52) des Gehäuses (42) befestigt ist.
